# EUROPÄISCHE PATENTSCHRIFT

(11) **EP 2 843 436 B1**
(45) Veröffentlichungstag und Bekanntmachung des Hinweises auf die Patenterteilung: **17.07.2019**
(21) Anmeldenummer: 14180833.7
(22) Anmeldetag: 13.08.2014
(51) Int. Cl.: G01R 33/30

(54) **NMR-Spektrometer mit ergonomisch günstigem Probenwechsler**
NMR spectrometer with ergonomically favourable sample exchanger
Spectromètre NMR doté d'un changeur d'échantillons avantageux, ergonomique

(30) Priorität: 29.08.2013 DE 102013217227
(43) Veröffentlichungstag der Anmeldung: 04.03.2015
(73) Patentinhaber: Bruker BioSpin GmbH, 76287 Rheinstetten (DE)
(72) Erfinder: Bocher, Thomas, 76227 Karlsruhe (DE); Maier, Diether, 76287 Rheinstetten (DE); Reiss, Volker, 76751 Jockgrim (DE)
(74) Vertreter: Kohler Schmid Möbus Patentanwälte

(56) Entgegenhaltungen:
- JP-A- H0 587 899
- JP-A- 2006 234 539
- US-A- 4 581 583
- Anonymous: "Almanac 2011 - Analytical Tables and Product Overview, Seiten 88-90", Online Internet Article, 2011, Seite 1,87-90, XP002734778, Gefunden im Internet: URL:https://www.lsa.umich.edu/UMICH/chem/H ome/Resources/Technical%20Services/NMR/Bru kerAlmanac2011.pdf [gefunden am 2015-01-21]

## Beschreibung

Die Erfindung betrifft ein NMR(=Kernspinresonanz)-Spektrometer umfassend eine Magnetanordnung mit einer im Wesentlichen vertikal ausgerichteten länglichen oberen Aufnahmeöffnung zur Aufnahme einer längs einer Probenachse ausgedehnten länglichen NMR-Probe, insbesondere in einem Probenröhrchen, mit einem Messvolumen, in welchem die längliche NMR-Probe während der Durchführung einer NMR-Messung in einer Messposition mit vertikal ausgerichteter Probenachse positioniert ist, sowie mit einem Probenwechsler mit mindestens einem zylinderförmigen Probenhalter zur Aufnahme der NMR-Probe an einer Ladeposition und zur Übergabe der NMR-Probe in das Messvolumen an einer Übergabeposition, wobei der Probenhalter zur Aufnahme der länglichen NMR-Probe nach oben hin geöffnet ist, wobei der Probenhalter derart gelagert ist, dass die Zylinderachse des zylinderförmigen Probenhalters des Probenwechslers an der Ladeposition um einen Neigungswinkel α zwischen 30 und 60 Grad gegenüber der Vertikalen geneigt ist, während sie nach einer Drehung in die Übergabeposition vertikal verläuft, und wobei eine Positioniervorrichtung vorhanden ist, welche die NMR-Probe an der Übergabeposition oder nach Durchlaufen derselben in die Messposition im Messvolumen mit vertikal ausgerichteter Probenachse der NMR-Probe überführt.

Ein solches NMR-Spektrometer mit einer vertikal von oben zu beschickenden Probenwechseleinrichtung ist beschrieben in JP H05 87899 A. Andere NMR-Spektrometer mit einer vertikal von oben zu beschickenden Probenwechseleinrichtung sind beschrieben in DE 37 29 819 A1 oder in US-A 5,534,780.

Spektroskopische Verfahren werden vielfach in der instrumentellen Analytik zur Untersuchung der chemischen Zusammensetzung von Proben eingesetzt. Zur Vermessung einer Probe wird beispielsweise in der NMR-Spektroskopie eine Probe in ein starkes statisches Magnetfeld verbracht und Hochfrequenz(=HF)-Pulse werden in die Probe eingestrahlt. Die Reaktion der Probe auf die HF-Pulse wird vermessen. Das statische Magnetfeld wird durch supraleitende Magnetspulen erzeugt; die Magnetspulen werden bei modernen hochauflösenden NMR-Spektrometern mit flüssigem Helium in einem Kryostaten gekühlt. Derartige NMR-Spektrometer haben eine Bauhöhe von mehr als einem Meter und sind nicht als Tischgeräte geeignet.

Aus dem Stand der Technik sind verschiedene Probenwechsler für NMR-Spektrometer bekannt. So zeigt etwa die oben zitierte US-A 5,534,780 einen Probenwechsler mit einer vertikalen Anordnung. NMR-Proben werden hier durch einen Schaltmechanismus in einer Übergabeposition freigegeben und pneumatisch in den Magneten weitergeleitet.

Die DE 10 2006 006 705 B4 beschreibt Details einer pneumatisch betriebenen Probenwechselvorrichtung für länglich ausgedehnte NMR-Probengläschen. Die Probengläschen werden hier in einen Probenhalter zum Fixieren und Transportieren eines Probengläschens eingefasst, wobei der Probenhalter die NMR-Probe direkt umgibt und sich mit dieser in das Messvolumen bewegt.

Um große und kostenintensive NMR-Spektrometer wirtschaftlich bestmöglich nutzen zu können, muss die Zeit für einen Wechsel zwischen verschiedenen Proben möglichst kurz gehalten werden. Zur Erzielung eines hohen Durchsatzes an Proben bei NMR-Spektrometern werden daher oft automatische Probenwechsler eingesetzt. Bei diesen bekannten NMR-Spektrometern erfolgt ein automatischer Probenwechsel durch Überführen einer Probe von einem Probenlager mit einer Vielzahl von Proben zu einem Messort in der Raumtemperaturbohrung des Kryostaten und zurück.

Bei kleineren und kompakteren NMR-Spektrometern hingegen erfolgt die Beschickung mit NMR-Proben meist von Hand, wobei jedoch gerade bei NMR-Tischgeräten die Zugänglichkeit bei der Übergabe einer NMR-Probe an das NMR-Spektrometer bislang ergonomisch ungünstig gelöst ist. Bedingt durch die Bauhöhe und die üblichen Abmessungen des Gerätes müssen Proben bisher vertikal von oben in ein Messvolumen im Bereich des Magneten eingeführt werden. Dabei muss die Bedienperson des Gerätes ihren Arm normalerweise relativ weit strecken, was bei häufiger Durchführung von Proben-Beschickung und Proben-Wechsel als anstrengend und unangenehm empfunden wird.

### Aufgabe der Erfindung

Der vorliegenden Erfindung liegt demgegenüber die Aufgabe zugrunde, mit geeigneten Maßnahmen eine ergonomisch günstigere Probenzufuhr an einem NMR-Spektrometer zu ermöglichen.

### Kurze Beschreibung der Erfindung

Diese Aufgabe wird gelöst durch ein NMR-Spektrometer mit den eingangs genannten Merkmalen, das dadurch gekennzeichnet ist, dass der Probenwechsler mehrere Probenhalter zur Bevorratung von NMR-Proben umfasst, und dass der Probenwechsler entweder eine um eine horizontale Drehachse drehbare, zweiteilige Tandem-Wippe umfasst, die zwei Probenhalter aufweist, von denen der erste in der schrägen Ladeposition stehen kann, während der zweite in der vertikalen Übergabeposition steht, oder dass der Probenwechsler als ein Kegelkarussell ausgestaltet ist, das um eine gegenüber der Vertikalen geneigte Drehachse drehbar ist, um den Wechsel von der Ladeposition zur Übergabeposition durchzuführen, wobei der Winkel der Drehachse zur Vertikalen zwischen 15 und 30 Grad beträgt.

Damit werden eine wesentliche Verbesserung der Ergonomie und eine leichtere Handhabung durch das Bedienpersonal erreicht.

Durch die Beschränkung des Winkelbereichs auf minimal etwa 30 Grad wird ein Ausfließen einer flüssigen NMR-Probe aus einem Probenröhrchen mit hohem Füllstand beim Verbringen in die Probenhalterung vermieden. Auch wird vermieden, dass die Flüssigkeitssäule sich dabei zu weit aus dem Gleichgewicht mit einem in der Mitte des Röhrchens waagerechten Meniskus bewegt, was bei dem Wechsel der NMR-Probe in die vertikale Messposition zu einer ungewollten Ausgleichsbewegung der flüssigen Probe und damit zu einem ungleichmäßigen Meßsignal führen würde.

### Bevorzugte Ausführungsformen und Weiterbildungen

Bei einer vorteilhaften Ausführungsform beträgt der Neigungswinkel α der Zylinderachse des Probenhalters an der Ladeposition zwischen 40 und 50 Grad gegenüber der Vertikalen, wodurch - gemäß den Auswertungen statistischer Erhebungen - für die allermeisten Bedienungspersonen in einem ausreichenden "breiten" Körpergrößen-Bereich und für eine angenommene mittlere Tischhöhe von 70 cm besonders günstige ergonomische Bedingungen zum Bedienen des NMR-Spektrometers bereitgestellt werden können. Der Winkelbereich von 40 bis 50 Grad entspricht dem Winkelbereich, in dem die menschliche Hand entspannt eine längliche NMR-Probe zur Verbringung in ein NMR-Spektrometer halten kann.

Bei einer bevorzugten Ausführungsform weist der Probenhalter eine trichterförmige Öffnung zur erleichterten Aufnahme einer NMR-Probe auf. Hierdurch wird die Zentrierung der NMR-Probe beim Einführen in den Probenhalter erleichtert. Außerdem erhält der Nutzer eine haptische Rückmeldung über die Positionierung der Probe im Probenhalter.

Über den Probenwechsler wird die an der Ladeposition eingeführte und durch eine Sperrvorrichtung gehaltene NMR-Probe an die Übergabeposition verbracht. Bevorzugt sind dabei Ausführungsformen des erfindungsgemäßen NMR-Spektrometers, die sich dadurch auszeichnen, dass der Probenhalter eine elektrisch gesteuerte Sperrvorrichtung aufweist, die an der Übergabeposition die NMR-Probe freigibt. Die Wechselbewegung wird vorzugsweise automatisch nach Probeneinführung und Schließen einer Probenabdeckung mit einem Motor durchgeführt. Hierdurch wird der Messablauf vereinfacht, da der Benutzer des Gerätes lediglich die Probe einzuführen braucht und die Messung danach automatisch startet.

Besonders vorteilhaft sind auch Ausführungsformen der Erfindung, bei welchen das NMR-Spektrometer eine Vorrichtung zum pneumatischen Absenken und Anheben einer NMR-Probe an der Übergabeposition umfasst. Hierdurch wird eine schonende Übergabe der NMR-Probe in das Messvolumen gewährleistet. Außerdem lässt sich der Luftfluss vom Messvolumen zum Probenträger im Messvolumen ohne weitere Hilfsmittel, die den dortigen Bauraum beschränken würden, steuern.

Für eine bessere Messwertemittelung sind Ausführungsformen vorteilhaft, bei denen das NMR-Spektrometer eine Vorrichtung zum pneumatischen Drehen ("Spinning") einer NMR-Probe im Bereich des Messvolumens umfasst. Die Aufnahmevorrichtung im Messvolumen enthält hierfür Strömungsdüsen mit einer tangentialen Komponente. Insbesondere werden durch das Drehen Asymmetrien der Probe und der Messapparatur herausgemittelt. Typische Drehfrequenzen liegen bei einigen 10 Hertz.

Bei weiteren bevorzugten Ausführungsformen des erfindungsgemäßen NMR-Spektrometers kann die Magnetanordnung einen Hufeisenmagneten, einen Ringmagneten oder einen beliebig geformten Segmentmagneten umfassen, der eine vertikale Öffnung aufweist. Durch die vertikale Öffnung wird erreicht, dass die Probe vom Probenwechsler in den Magneten aufgrund der Schwerkraft eingebracht werden kann. Außerdem ist eine pneumatisch betriebene Drehbewegung einer länglichen NMR-Probe nur in einer vertikalen Orientierung der NMR-Probe in dem Messvolumen vorteilhaft zu realisieren. Eine Abweichung von wenigen Grad führt bereits zu ungleichmäßigen Ergebnissen in der NMR-Messung.

Vorzugsweise ist der Neigungswinkel α der Zylinderachse des Probenhalters an der Ladeposition verstellbar. Hiermit kann eine Anpassung an die individuellen Gegebenheiten wie Körpergröße und/oder Tischhöhe vorgenommen werden. So ist beispielweise ein Standard NMR-Spektrometer mit einem Neigungswinkel α von 50 Grad versehen, kann aber für einen Benutzer mit einer hohen Körpergröße auf einen Winkel von z.B. 40 Grad verstellt werden.

Um störende Einflüsse der Umwelt zu vermeiden sowie auch aus sicherheitstechnischen Gründen kann bei vorteilhaften Ausführungsformen der Erfindung der Probenwechsler mit einer Abdeckung versehen sein, die während des Beladens des NMR-Spektrometers mit einer oder mehreren NMR-Proben zu öffnen ist. Da Probenröhrchen für NMR-Proben aus Flüssigkeiten oft aus Glas bestehen und diese im Probenvolumen pneumatisch rotiert werden, ist es wichtig, die Öffnungen des Probenwechslers beim Messbetrieb abzudecken. Bei Glasbruch würden Splitter auf diese Weise im Gerät verbleiben und keine Verletzungen des Benutzers verursachen.

Die Abdeckung kann auch einen elektronischen oder mechanischen Schaltkontakt umfassen, der das semiautomatische Wechseln der NMR-Probe auslöst.

Ganz besonders bevorzugt ist eine Weiterbildung dieser Ausführungsformen, bei der der Probenwechsler einen Motor umfasst, der nach Einbringung einer NMR-Probe in der Ladeposition und Schließen der Abdeckung den Probenwechsler so bewegt, dass die NMR-Probe in die Übergabeposition gebracht wird. Hierdurch wird die Bedienung des NMR-Spektrometers durch den Benutzer weiter vereinfacht, da er keinen weiteren Knopf am NMR-Spektrometer oder in einer NMR-Software für die Auslösung einer NMR-Messung betätigen muss.

Die Ausbildung des Probenwechslers als zweiteilige Tandem-Wippe ist verhältnismäßig einfach und kostengünstig zu realisieren.

Bei einer besonders günstigen Weiterbildung der Ausführung des Probenwechslers als Kegelkarussell beträgt der Winkel der Drehachse zur Vertikalen zwischen 20 und 25 Grad.

Für einen hohen Durchsatz und damit einen kostengünstigen Betrieb des erfindungsgemäßen NMR-Spektrometers ist es ganz besonders vorteilhaft, wenn der Probenwechsler weitere Probenhalter zur Bevorratung von NMR-Proben umfasst, in die weitere NMR-Proben zur Bevorratung eingebracht werden können. So kann nach Beladung des Probenwechslers eine Serie von Messungen durchgeführt werden. In Bezug auf die Anpassung des Neigungswinkel α ist dabei anzumerken, dass der Probenwechsler dann bei Einbringen einer NMR-Probe in den Probenhalter in der Ladeposition nicht gleichzeitig in einer anderen Position des Probenwechslers in der Übergabeposition ist. Hierfür muss eine weitere Drehung des Probenwechslers um diesen zusätzlichen Winkel erfolgen. Das NMR-Spektrometer und die Probenröhrchen für eine NMR-Probe sind im Allgemeinen aber so ausgeführt, dass eine längliche NMR-Probe vollständig in das Messvolumen passt, ohne in den Probenwechsler hineinzuragen. Hierdurch wird eine Zerstörung der NMR-Probe durch eine Wechselbewegung des Probenwechslers vermieden.

Eine besonders bevorzugte Weiterbildung dieser Ausführungsformen ist dadurch gekennzeichnet, dass in einem weiteren Probenhalter eine Kalibrierprobe für eine Kalibrierung und Selbstüberwachung des NMR-Spektrometers eingebracht ist. Hiermit kann im Wechsel zu jeder Probenmessung eine Kalibrierung durchgeführt werden, um die Einstellungen des NMR-Spektrometers zu überprüfen und gegebenenfalls zu korrigieren. Beispielsweise können auf diese Weise die Ströme von Shim-Spulen, die den Probenkopf des Spektrometers umgeben, korrigiert werden, damit die Homogenität des Magnetfeldes im Messvolumen den Vorgaben entspricht. Auch können Einflüsse der Umwelt wie zum Beispiel Temperatur und Luftfeuchte auf das NMR-Spektrometer überwacht und gegebenenfalls ausgeglichen werden.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung. Insbesondere ist ein erfindungsgemäßer Probenwechsler auch für NMR-Spektrometer mit Kryostaten vorteilhaft, weil hier die vertikal ausgerichtete längliche Aufnahmeöffnung auch mit einer Leiter oder einem Tritt schlecht zu erreichen und insbesondere schlecht zu sehen ist. Eine um mindestens 30 Grad geneigte Ladeposition eines Probenwechslers würde auch hier den Bedienkomfort deutlich erhöhen.

### Zeichnung und detaillierte Beschreibung der Erfindung

Die Erfindung ist in der Zeichnung dargestellt und wird anhand von Ausführungsbeispielen näher erläutert. Es zeigen:
- Fig. 1a: eine - stark abstrahierte - schematische Darstellung eines NMR-Spektrometers mit einer einfachen Probenwechseleinrichtung die nur einen einzigen zylinderförmigen Probenhalter aufweist, wobei der Probenhalter mit seiner Zylinderachse in der schrägen Ladeposition um einen Neigungswinkel α gegenüber der Vertikalen geneigt steht;
- Fig. 1b: wie Fig. 1a, aber mit der Zylinderachse des Probenhalters in der vertikalen Übergabeposition;
- Fig.2a: eine schematische Seitenansicht eines erfindungsgemässen Probenwechslers in Form einer um eine horizontale Drehachse drehbare Wippe mit zwei Probenhaltern, von denen der erste in der schrägen Ladeposition, der zweite in der vertikalen Übergabeposition steht;
- Fig. 2b: den Probenwechsler von Fig. 2a, aber mit dem ersten Probenhalter in der vertikalen Übergabeposition und dem zweiten Probenhalter in einer schrägen Bevorratungsposition um einen Neigungswinkel α gegenüber der Vertikalen geneigt;
- Fig. 2c: eine schematische Draufsicht auf den Probenwechsler mit in durchgezogener Linie dargestellter Situation gemäß Fig. 2a und mit gepunkteter Linie dargestellter Situation gemäß Fig. 2b;
- Fig. 2d: eine schematische, teilweise transparente räumliche Seitenansicht eines Probenwechslers nach den Figuren 2a bis 2c;
- Fig. 3a: eine schematische Seitenansicht eines erfindungsgemässen NMR-Spektrometers, bei der der Probenwechsler als ein Kegelkarussell ausgestaltet ist, das um eine gegenüber der Vertikalen geneigte Drehachse drehbar ist, mit insgesamt sechs Probenhaltern, von denen der erste in der schrägen Ladeposition steht, der vierte in der vertikalen Übergabeposition und die übrigen jeweils in schrägen Bevorratungspositionen;
- Fig. 3b: das Spektrometer von Fig. 3a in schematischer Draufsicht auf die Probenhalter des Kegelkarussells;
- Fig. 4a: eine räumliche Darstellung eines NMR-Spektrometers ohne Abdeckung des Probenwechslers;
- Fig. 4b: eine Draufsicht auf das Beispiel der Fig. 4a;
- Fig. 4c: ein Beispiel wie in Fig. 4a, jedoch mit Abdeckung des Probenwechslers; und
- Fig. 4d: eine Draufsicht auf das Beispiel nach Fig. 4c.

Sämtliche Ausführungsformen des erfindungsgemäßen **NMR-Spektrometers 1; 1'; 1"; 1'''** weisen jeweils eine **Magnetanordnung 2** auf, die einen Hufeisenmagneten, einen segmentierten Magneten oder einen Ringmagneten umfassen kann, mit einer im Wesentlichen vertikal ausgerichteten länglichen Aufnahmeöffnung zur Aufnahme einer längs einer Probenachse ausgedehnten länglichen NMR-Probe, die sich üblicherweise in einem Probenröhrchen befindet. Die längliche NMR-Probe ist während der Durchführung einer NMR-Messung in einer Messposition mit vertikal ausgerichteter Probenachse in einem **Messvolumen 3** in dem von der Magnetanordnung 2 erzeugten Feld positioniert.

Das NMR-Spektrometer 1; 1'; 1"; 1''' verfügt über einen **Probenwechsler 4; 4'**; **4"; 4'''** mit mindestens einem zylinderförmigen **Probenhalter 7; 7',7"; 7a,7b,7c,7d,7e,7f** zur Aufnahme der NMR-Probe an einer **Ladeposition 5** und zur Übergabe der NMR-Probe in das Messvolumen 3 an einer **Übergabeposition 6.**

Erfindungsgemäß zeichnen sich die NMR-Spektrometer 1; 1'; 1"; 1''' dadurch aus, dass die Zylinderachse des zylinderförmigen Probenhalters 7; 7',7"; 7a,7b,7c,7d,7e,7f des Probenwechslers 4; 4'; 4"; 4''' an der Ladeposition 5 um einen **Neigungswinkel α** zwischen 30 und 60 Grad, vorzugsweise zwischen 40 und 50 Grad, gegenüber der Vertikalen geneigt ist, während sie an der Übergabeposition 6 vertikal verläuft, und dass eine Positioniervorrichtung vorhanden ist, welche die NMR-Probe an der Übergabeposition 6 oder nach Durchlaufen derselben in die Messposition im Messvolumen 3 mit vertikal ausgerichteter Probenachse der NMR-Probe überführt.

Der Neigungswinkel α der Zylinderachse des Probenhalters 7; 7',7"; 7a,7b,7c,7d,7e,7f an der Ladeposition 5 wird günstiger weise verstellbar ausgeführt sein.

Auch kann der Probenhalter 7; 7',7"; 7a,7b,7c,7d,7e,7f eine trichterförmige Öffnung zur erleichterten Aufnahme der NMR-Probe aufweisen, die allerdings in den Figuren der Zeichnung nicht näher dargestellt ist.

Ebenfalls in der Zeichnung nicht gezeigt sind vorteilhafte Ausgestaltungen des erfindungsgemäßen NMR-Spektrometers, die eine elektrisch gesteuerte Sperrvorrichtung, die an der Übergabeposition 6 die NMR-Probe freigibt, und/oder eine Vorrichtung zum pneumatischen Absenken und Anheben der NMR-Probe an der Übergabeposition 6, und/oder eine Vorrichtung zum pneumatischen Drehen der NMR-Probe im Bereich des Messvolumens 3 aufweisen können.

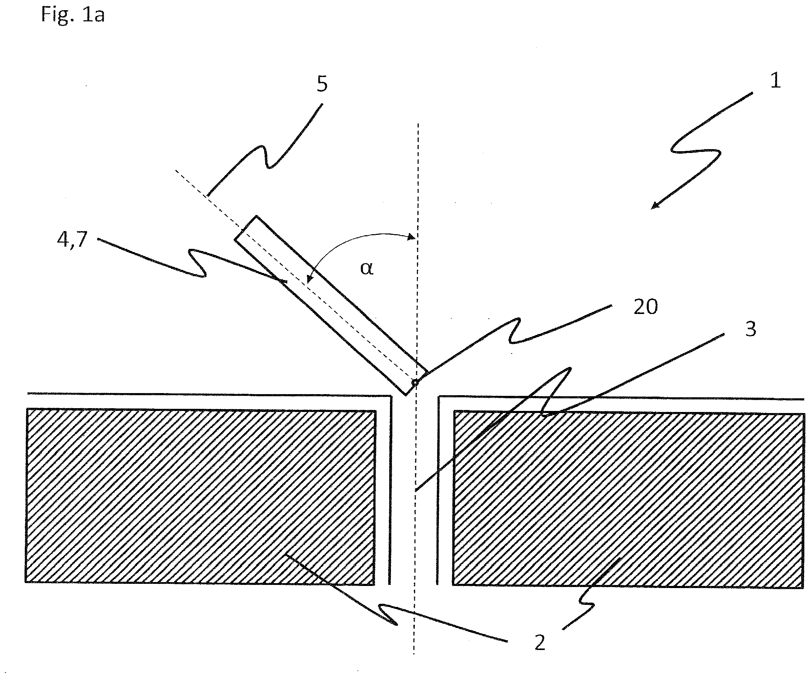

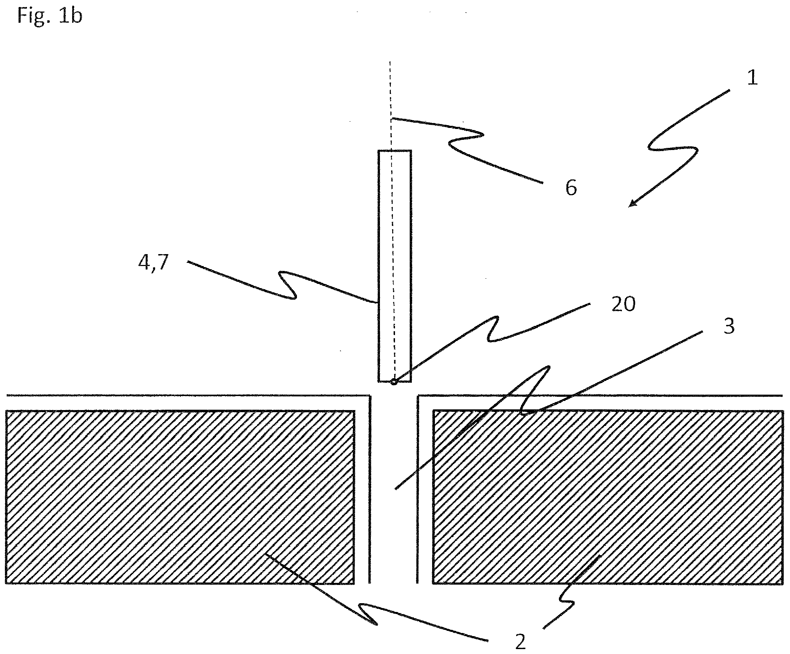

**Figur 1a** zeigt - stark schematisiert - ein Beispiel eines NMR-Spektrometers 1, welches eine sehr einfache Probenwechseleinrichtung aufweist, die nur einen einzigen zylinderförmigen Probenhalter 7 enthält. Dieser ist um eine **horizontale Drehachse 20** aus der in Fig. 1a dargestellten, um den Neigungswinkel α gegenüber der Vertikalen geneigten schrägen Ladeposition 5 in die in **Figur 1b** gezeigte vertikale Übergabeposition 6 verkippbar.

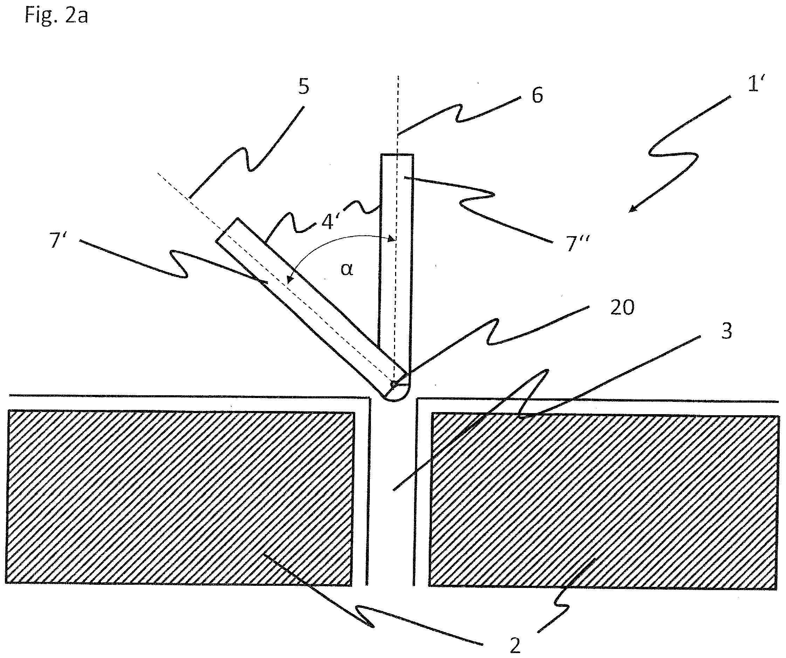

In **Figur 2a** ist ein erfindungsgemässes NMR-Spektrometer 1' mit einem Probenwechsler 4' in Form einer um die horizontale Drehachse 20 drehbare Wippe dargestellt, die zwei Probenhalter 7', 7" aufweist, von denen in Fig. 2a der erste in der schrägen Ladeposition 5, während der zweite in der vertikalen Übergabeposition 6 steht.

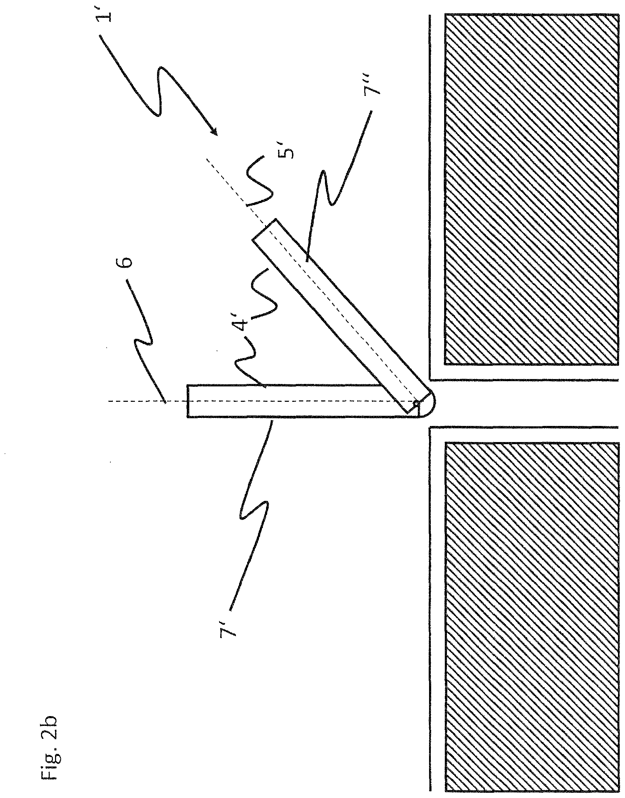

Demgegenüber ist in **Figur 2b** der Probenwechsler von Fig. 2a in einer Position dargestellt, in welcher der erste Probenhalter 7' in der vertikalen Übergabeposition 6 und der zweite Probenhalter 7" in einer schrägen **Bevorratungsposition 5'** um einen Neigungswinkel α gegenüber der Vertikalen geneigt ist.

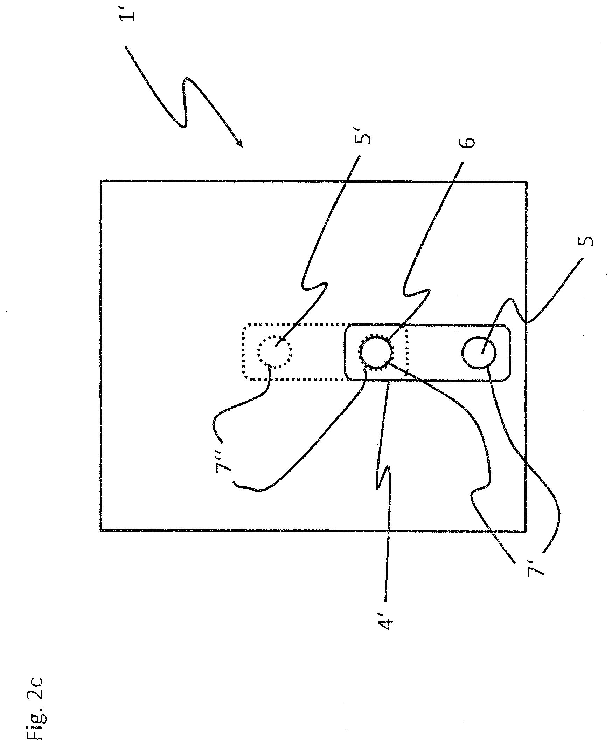

**Figur 2c** verdeutlicht die beiden in den Figuren 2a und 2b gezeigten Positionen der beiden Probenhalter 7', 7" in einer schematischen Draufsicht. Mit durchgezogener Linie ist hierbei die Situation gemäß Fig. 2a und mit gepunkteter Linie die Situation gemäß Fig. 2b dargestellt.

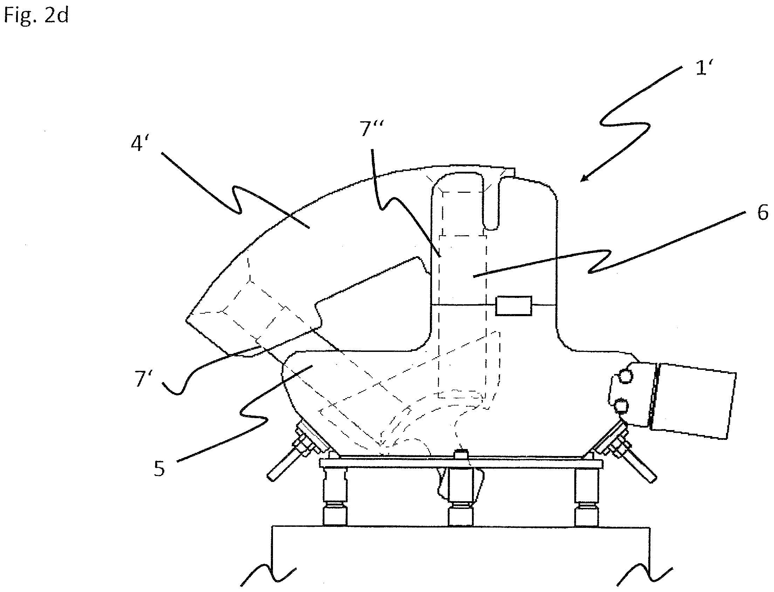

Im Gegensatz zu den sehr stark abstrahierten Darstellungen des erfindungsgemäßen NMR-Spektrometers 1' in den Figuren 2a bis 2c zeigt **Figur 2d** eine teilweise transparente räumliche Seitenansicht des Probenwechslers 4', welcher auf einem hier nur angedeuteten Magnet-Aufbau steht.

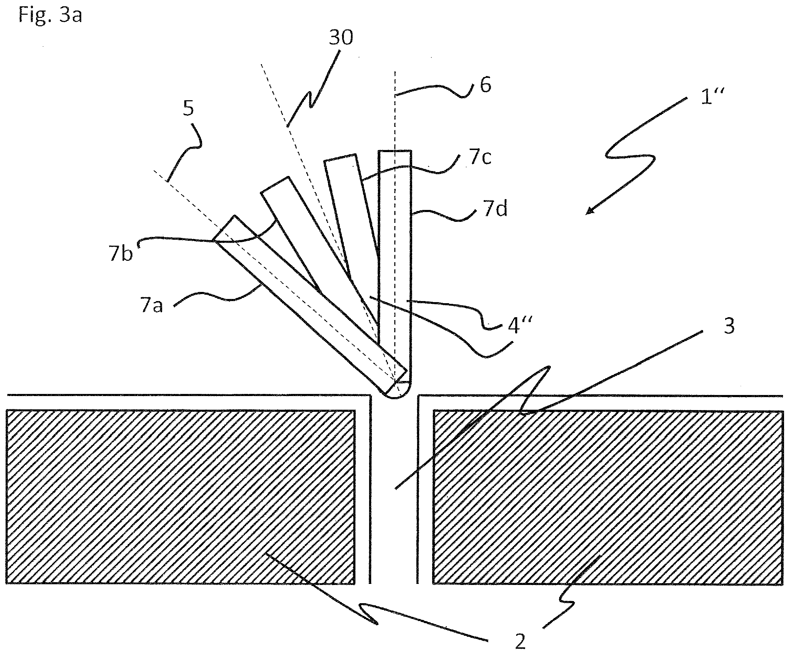

**Figur 3a** zeigt eine schematische Seitenansicht eines erfindungsgemäßen NMR-Spektrometers 1", bei der der Probenwechsler 4" als ein um eine gegenüber der Vertikalen geneigte **Drehachse 30** drehbares Kegelkarussell ausgestaltet ist, deren Winkel zur Vertikalen in der Regel zwischen 15 und 30 Grad, vorzugsweise zwischen 20 und 25 Grad beträgt.

Das Kegelkarussell ist mit insgesamt sechs Probenhaltern 7a, 7b, 7c, 7d, 7e, 7f ausgestattet, von denen der erste (7a) in der schrägen Ladeposition 5 steht, der vierte (7d) in der vertikalen Übergabeposition 6 und die übrigen (7b, 7c, 7e, 7f) jeweils in schrägen Bevorratungspositionen. In einem der Probenhalter 7a, 7b, 7c, 7d, 7e, 7f kann eine Kalibrierprobe für eine Kalibrierung und Selbstüberwachung des NMR-Spektrometers 1" eingebracht sein.

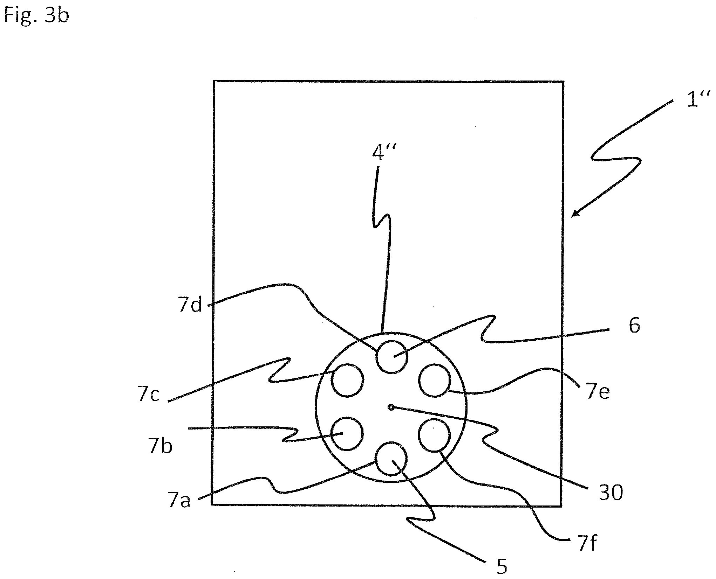

**Figur 3b** zeigt den in Fig. 3a dargestellten Probenwechsler in schematischer Draufsicht auf die sechs Probenhalter 7a, 7b, 7c, 7d, 7e, 7f des Kegelkarussells.

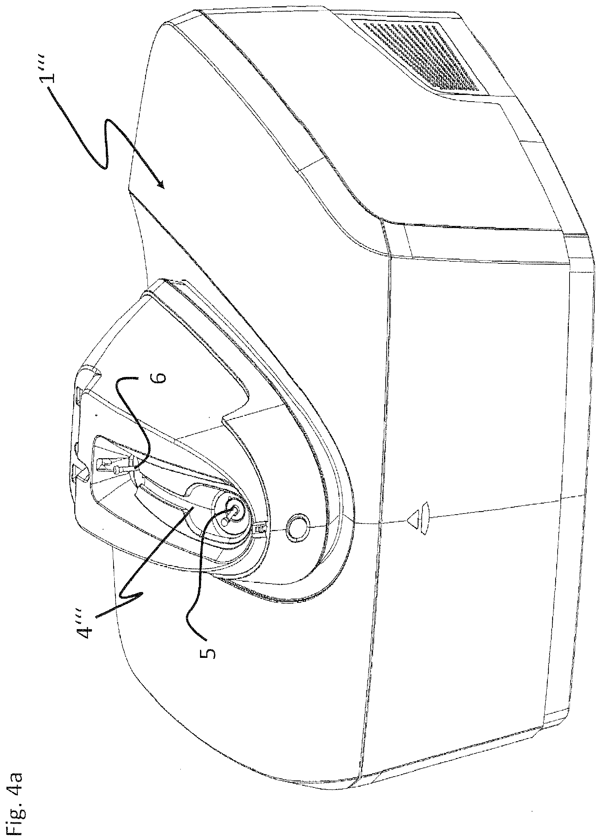

**Figur 4a** zeigt in räumlicher Darstellung ein NMR-Spektrometer 1''' mit einem nicht-abgedeckten Probenwechsler 4''', wobei sich die Ladeposition 5 des Probenwechslers 4''' in einem vorderen Bereich des NMR-Spektrometers 1''' befindet. Letzteres weist zusätzlich im vorderen Bereich eine Abschrägung auf, die den besseren Zugang zur Ladeposition 5 auch von der Seite ermöglicht.

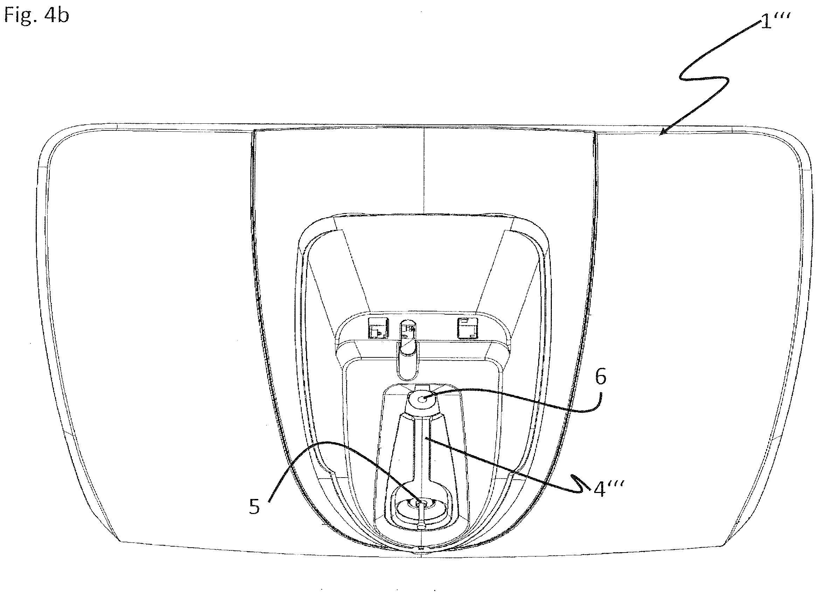

**Figur 4b** stellt eine Draufsicht auf das Beispiel der Fig. 4a dar.

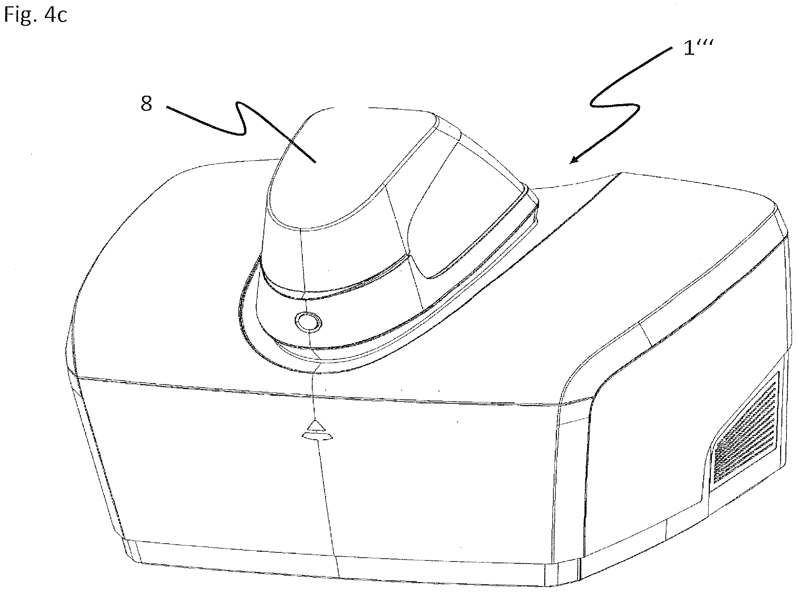

**Figur 4c** zeigt das Beispiel von Fig. 4a, jedoch mit einer **Abdeckung 8** des Probenwechslers 4''' in geschlossenem Zustand. Diese Abdeckung 8 kann - wie in den Figuren 4a und 4b gezeigt - zum Beladen des NMR-Spektrometers 1''' mit einer oder mehreren NMR-Proben geöffnet werden.

Der Probenwechsler 4''' kann einen - in der Zeichnung nicht dargestellten - Motor umfassen, der nach Einbringung einer NMR-Probe in der Ladeposition 5 und Schließen der Abdeckung 8 den Probenwechsler 4''' so bewegt, dass die NMR-Probe in die Übergabeposition 6 gebracht wird.

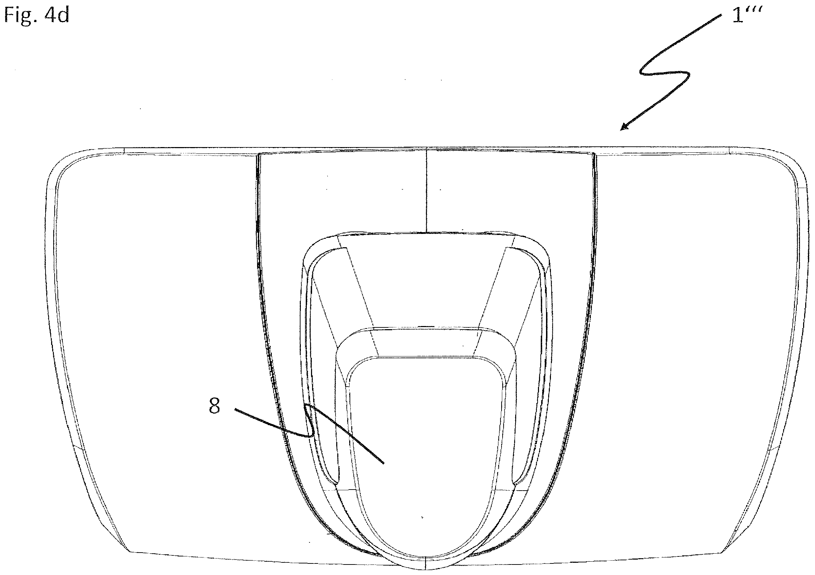

**Figur 4d** schließlich zeigt eine Draufsicht auf das in Fig. 4c dargestellte NMR-Spektrometer 1'''.

## Patentansprüche

1. NMR(=Kernspinresonanz)-Spektrometer (1; 1'; 1"; 1''') umfassend eine Magnetanordnung (2) mit einer vertikal ausgerichteten länglichen oberen Aufnahmeöffnung zur Aufnahme einer längs einer Probenachse ausgedehnten länglichen NMR-Probe, insbesondere in einem Probenröhrchen, mit einem Messvolumen (3), in welchem die längliche NMR-Probe während der Durchführung einer NMR-Messung in einer Messposition mit vertikal ausgerichteter Probenachse positioniert ist, sowie mit einem Probenwechsler (4; 4'; 4"; 4''') mit mindestens einem zylinderförmigen Probenhalter (7; 7',7"; 7a,7b,7c,7d,7e,7f) zur Aufnahme der NMR-Probe an einer Ladeposition (5) und zur Übergabe der NMR-Probe in das Messvolumen (3) an einer Übergabeposition (6),wobei der Probenhalter (7; 7',7"; 7a,7b,7c,7d,7e,7f) zur Aufnahme der länglichen NMR-Probe nach oben hin geöffnet ist, wobei der Probenhalter (7; 7',7"; 7a,7b,7c,7d,7e,7f) derart gelagert ist, dass die Zylinderachse des zylinderförmigen Probenhalters (7; 7',7"; 7a,7b,7c,7d,7e,7f) des Probenwechslers (4; 4'; 4"; 4''') an der Ladeposition (5) um einen Neigungswinkel α zwischen 30 und 60 Grad gegenüber der Vertikalen geneigt ist, während sie nach einer Drehung in die Übergabeposition (6) vertikal verläuft, und wobei eine Positioniervorrichtung vorhanden ist, welche die NMR-Probe an der Übergabeposition (6) oder nach Durchlaufen derselben in die Messposition im Messvolumen (3) mit vertikal ausgerichteter Probenachse der NMR-Probe überführt;
**dadurch gekennzeichnet,**
**dass** der Probenwechsler (4'; 4"; 4''') mehrere Probenhalter (7',7"; 7a,7b,7c,7d,7e,7f) zur Bevorratung von NMR-Proben umfasst,
und **dass** der Probenwechsler (4'; 4''') entweder eine um eine horizontale Drehachse (20) drehbare, zweiteilige Tandem-Wippe umfasst, die zwei Probenhalter (7', 7") aufweist, von denen der erste in der schrägen Ladeposition (5) stehen kann, während der zweite in der vertikalen Übergabeposition (6) steht,
oder dass der Probenwechsler (4") als ein Kegelkarussell ausgestaltet ist, das um eine gegenüber der Vertikalen geneigte Drehachse (30) drehbar ist, um den Wechsel von der Ladeposition (5) zur Übergabeposition (6) durchzuführen, wobei der Winkel der Drehachse (30) zur Vertikalen zwischen 15 und 30 Grad beträgt.

2. NMR-Spektrometer nach Anspruch 1, **dadurch gekennzeichnet, dass** der Neigungswinkel α der Zylinderachse des Probenhalters (7; 7',7"; 7a,7b,7c,7d,7e,7f) an der Ladeposition (5) zwischen 40 und 50 Grad gegenüber der Vertikalen beträgt.

3. NMR-Spektrometer nach einem der vorhergehenden Ansprüche,
**dadurch gekennzeichnet, dass** der Probenhalter (7; 7',7"; 7a,7b,7c,7d,7e,7f) eine trichterförmige Öffnung zur erleichterten Aufnahme der NMR-Probe aufweist.

4. NMR-Spektrometer nach einem der vorhergehenden Ansprüche,
**dadurch gekennzeichnet, dass** der Probenhalter (7; 7',7"; 7a,7b,7c,7d,7e,7f) eine elektrisch gesteuerte Sperrvorrichtung aufweist, die an der Übergabeposition (6) die NMR-Probe freigibt.

5. NMR-Spektrometer nach einem der vorhergehenden Ansprüche,
**dadurch gekennzeichnet, dass** das NMR-Spektrometer (1; 1'; 1"; 1''') eine Vorrichtung zum pneumatischen Absenken und Anheben der NMR-Probe an der Übergabeposition (6) umfasst.

6. NMR-Spektrometer nach einem der vorhergehenden Ansprüche,
**dadurch gekennzeichnet, dass** das NMR-Spektrometer (1; 1'; 1"; 1''') eine Vorrichtung zum pneumatischen Drehen der NMR-Probe im Bereich des Messvolumens (3) umfasst.

7. NMR-Spektrometer nach einem der vorhergehenden Ansprüche,
**dadurch gekennzeichnet, dass** die Magnetanordnung (2) einen Hufeisenmagneten, einen segmentierten Magneten oder einen Ringmagneten umfasst.

8. NMR-Spektrometer nach einem der vorhergehenden Ansprüche,
**dadurch gekennzeichnet, dass** der Neigungswinkel α der Zylinderachse des Probenhalters (7; 7',7"; 7a,7b,7c,7d,7e,7f) an der Ladeposition (5) verstellbar ist.

9. NMR-Spektrometer nach einem der vorhergehenden Ansprüche,
**dadurch gekennzeichnet, dass** der Probenwechsler (4; 4'; 4"; 4''') mit einer Abdeckung (8) versehen ist, die zum Beladen des NMR-Spektrometers (1; 1'; 1"; 1''') mit einer oder mehreren NMR-Proben zu öffnen ist.

10. NMR-Spektrometer nach Anspruch 9, **dadurch gekennzeichnet, dass** der Probenwechsler (4; 4'; 4"; 4''') einen Motor umfasst, der nach Einbringung einer NMR-Probe in der Ladeposition (5) und Schließen der Abdeckung (8) den Probenwechsler (4; 4'; 4"; 4''') so bewegt, dass die NMR-Probe in die Übergabeposition (6) gebracht wird.

11. NMR-Spektrometer nach einem der vorhergehenden Ansprüche,
**dadurch gekennzeichnet, dass** der Winkel der Drehachse (30) zur Vertikalen zwischen 20 und 25 Grad beträgt.

12. NMR-Spektrometer nach einem der vorhergehenden Ansprüche,
**dadurch gekennzeichnet, dass** in einem weiteren Probenhalter (7"; 7a,7b,7c,7e,7f) eine Kalibrierprobe für eine Kalibrierung und Selbstüberwachung des NMR-Spektrometers (1'; 1"; 1''') eingebracht ist.

## Claims

1. NMR(=nuclear magnetic resonance) spectrometer (1; 1'; 1"; 1''') comprising a magnet configuration (2) with a vertically aligned elongated upper receiving opening for receiving an elongated NMR sample extending along a sample axis, in particular, in a sample vial, with a measurement volume (3), in which, while an NMR measurement is being performed, the elongated NMR sample is positioned in a measuring position with a vertically aligned sample axis, and with a sample changer (4; 4'; 4"; 4''') with at least one cylindrical sample holder (7; 7',7"; 7a,7b,7c,7d,7e,7f) for receiving the NMR sample at a loading position (5) and for transferring the NMR sample into the measurement volume (3) at a transfer position (6), wherein the sample holder (7; 7',7"; 7a,7b,7c,7d,7e,7f) is open at the top for receiving the elongated NMR sample,
wherein the sample holder (7; 7',7"; 7a,7b,7c,7d,7e,7f) is mounted in such a manner that the cylinder axis of the cylindrical sample holder (7; 7',7"; 7a,7b,7c,7d,7e,7f) of the sample changer (4; 4'; 4"; 4''') at the loading position (5) is inclined by an angle of inclination α of between 30 and 60 degrees with respect to the vertical, while, after rotation into the transfer position (6), it extends vertically,
and wherein a positioning device is provided, which transfers the NMR sample at the transfer position (6) or after having passed through the latter, into the measuring position in the measurement volume (3) with a vertically aligned sample axis of the NMR sample,
**characterized in that**
the sample changer (4'; 4"; 4''') comprises multiple sample holders (7; 7',7"; 7a,7b,7c,7d,7e,7f) for storing NMR samples, and that the sample changer (4'; 4''') comprises either a two-part tandem rocker, which can be rotated about a horizontal axis of rotation (20) and comprises two sample holders (7', 7"), the first of which can be in the inclined loading position (5) while the second is in the vertical transfer position (6),
or that the sample changer (4") is designed as a conus roundabout which can be rotated about an axis of rotation (30) which is inclined with respect to the vertical in order to perform the change from the loading position (5) to the transfer position (6), wherein the angle of the axis of rotation (30) with respect to the vertical is between 15 and 30 degrees.

2. NMR spectrometer according to claim 1, **characterized in that** the angle of inclination α of the cylinder axis of the sample holder (7; 7',7"; 7a,7b,7c,7d,7e,7f) at the loading position (5) is between 40 and 50 degrees with respect to the vertical.

3. NMR spectrometer according to any one of the previous claims, **characterized in that** the sample holder (7; 7',7"; 7a,7b,7c,7d,7e,7f) has a funnel-shaped opening for easier reception of the NMR sample.

4. NMR spectrometer according to any one of the previous claims, **characterized in that** the sample holder (7; 7',7"; 7a,7b,7c,7d,7e,7f) has an electrically controlled locking device, which releases the NMR sample at the transfer position (6).

5. NMR spectrometer according to any one of the previous claims, **characterized in that** the NMR spectrometer (1; 1'; 1"; 1''') comprises a device for pneumatically lowering and raising the NMR sample at the transfer position (6).

6. NMR spectrometer according to any one of the previous claims, **characterized in that** the NMR spectrometer (1; 1'; 1"; 1''') comprises a device for pneumatically rotating the NMR sample in the region of the measurement volume (3).

7. NMR spectrometer according to any one of the previous claims, **characterized in that** the magnet configuration (2) comprises a horseshoe magnet, a segmented magnet, or a ring magnet.

8. NMR spectrometer according to any one of the previous claims, **characterized in that** the angle of inclination α of the cylinder axis of the sample holder (7; 7',7"; 7a,7b,7c,7d,7e,7f) at the loading position (5) is adjustable.

9. NMR spectrometer according to any one of the previous claims, **characterized in that** the sample changer (4; 4'; 4"; 4''') is equipped with a cover (8), which must be opened to load the NMR spectrometer (1; 1'; 1"; 1''') with one or more NMR samples.

10. NMR spectrometer according to claim 9, **characterized in that** the sample changer (4; 4'; 4"; 4''') comprises a motor, which, after inserting an NMR sample at the loading position (5) and closing the cover (8), moves the sample changer (4; 4'; 4"; 4''') in such a way that the NMR sample is brought into the transfer position (6).

11. NMR spectrometer according to any one of the previous claims, **characterized in that** the angle of the axis of rotation (30) with respect to the vertical is between 20 and 25 degrees.

12. NMR spectrometer according to any one of the previous claims, **characterized in that** in a further sample holder (7"; 7a,7b,7c,7e,7f) a calibration sample is inserted for calibrating and self-monitoring of the NMR spectrometer (1'; 1"; 1''').

## Revendications

1. Spectromètre RMN (résonance magnétique nucléaire) (1; 1'; 1"; 1''') comprenant un agencement magnétique (2) avec une ouverture de réception supérieure allongée orientée verticalement, destinée à recevoir un échantillon RMN allongé étendu le long d'un axe d'échantillon, en particulier dans un tube à échantillon, avec un volume de mesure (3) dans lequel l'échantillon RMN allongé est placé dans une position de mesure avec un axe d'échantillon orienté verticalement pendant une mesure RMN, et avec un changeur d'échantillons (4 ; 4' ; 4" ; 4"') doté d'au moins un support d'échantillon cylindrique (7 ; 7', 7" ; 7a, 7b, 7c, 7d, 7e, 7f) destiné à recevoir l'échantillon RMN à une position de chargement (5) et à transférer l'échantillon RMN à une position de transfert (6) dans le volume de mesure (3), dans lequel le support d'échantillon (7 ; 7', 7" ; 7a, 7b, 7c, 7d, 7e, 7f) destiné à recevoir l'échantillon RMN allongé est ouvert vers le haut, dans lequel le support d'échantillon (7 ; 7', 7" ; 7a, 7b, 7c, 7d, 7e, 7f) est monté de telle sorte que l'axe de cylindre du support d'échantillon cylindrique (7 ; 7', 7" ; 7a, 7b, 7c, 7d, 7e, 7f) du changeur d'échantillons (4 ; 4'; 4" ; 4''') à la position de chargement (5) est incliné d'un angle d'inclinaison α compris entre 30 et 60 degrés par rapport à la verticale, tandis qu'il s'étend verticalement après une rotation dans la position de transfert (6), et dans lequel un dispositif de positionnement est prévu, lequel transfère l'échantillon RMN dans la position de transfert (6) ou, après avoir traversé celle-ci, dans la position de mesure dans le volume de mesure (3) avec l'axe d'échantillon de l'échantillon RMN orienté verticalement ;
**caractérisé en ce**
**que** le changeur d'échantillons (4' ; 4" ; 4''') comprend plusieurs supports d'échantillon (7', 7" ; 7a, 7b, 7c, 7d, 7e, 7f) pour stocker des échantillons RMN,
et **que** le changeur d'échantillons (4' ; 4''') comprend une bascule en tandem en deux parties pouvant tourner autour d'un axe de rotation horizontal (20) et présentant deux supports d'échantillon (7', 7"), dont le premier peut se trouver dans la position de chargement inclinée (5) pendant que le second se trouve dans la position de transfert verticale (6),
ou que le changeur d'échantillons (4") est réalisé sous la forme d'un carrousel conique qui peut tourner autour d'un axe de rotation (30) incliné par rapport à la verticale pour effectuer le passage de la position de chargement (5) à la position de transfert (6), l'angle de l'axe de rotation (30) par rapport à la verticale étant compris entre 15 et 30 degrés.

2. Spectromètre RMN selon la revendication 1, **caractérisé en ce que** l'angle d'inclinaison α de l'axe de cylindre du support d'échantillon (7 ; 7', 7" ; 7a, 7b, 7c, 7d, 7e, 7f) à la position de chargement (5) est compris entre 40 et 50 degrés par rapport à la verticale.

3. Spectromètre RMN selon l'une des revendications précédentes, **caractérisé en ce que** le support d'échantillon (7 ; 7', 7" ; 7a, 7b, 7c, 7d, 7e, 7f) présente une ouverture en forme d'entonnoir pour faciliter la réception de l'échantillon RMN.

4. Spectromètre RMN selon l'une des revendications précédentes, **caractérisé en ce que** le support d'échantillon (7 ; 7', 7" ; 7a, 7b, 7c, 7d, 7e, 7f) présente un dispositif de verrouillage à commande électrique qui libère l'échantillon RMN à la position de transfert (6).

5. Spectromètre RMN selon l'une des revendications précédentes, **caractérisé en ce que** le spectromètre RMN (1 ; 1' ; 1" ; 1''') comprend un dispositif pour abaisser et relever pneumatiquement l'échantillon RMN à la position de transfert (6).

6. Spectromètre RMN selon l'une des revendications précédentes, **caractérisé en ce que** le spectromètre RMN (1 ; 1' ; 1" ; 1''') comprend un dispositif pour faire tourner pneumatiquement l'échantillon RMN dans la zone du volume de mesure (3).

7. Spectromètre RMN selon l'une des revendications précédentes, **caractérisé en ce que** l'agencement magnétique (2) comprend un aimant en fer à cheval, un aimant segmenté ou un aimant annulaire.

8. Spectromètre RMN selon l'une des revendications précédentes, **caractérisé en ce que** l'angle d'inclinaison α de l'axe de cylindre du support d'échantillon (7 ; 7', 7" ; 7a, 7b, 7c, 7d, 7e, 7f) est réglable à la position de chargement (5).

9. Spectromètre RMN selon l'une des revendications précédentes, **caractérisé en ce que** le changeur d'échantillons (4 ; 4' ; 4" ; 4''') est muni d'un couvercle (8) qui doit être ouvert pour charger un ou plusieurs échantillons RMN dans le spectromètre RMN(1 ; 1' ; 1" ; 1''').

10. Spectromètre RMN selon la revendication 9, **caractérisé en ce que** le changeur d'échantillons (4 ; 4' ; 4" ; 4''') comprend un moteur qui, après introduction d'un échantillon RMN dans la position de chargement (5) et fermeture du couvercle (8), déplace le changeur d'échantillons (4 ; 4' ; 4" ; 4"') de telle sorte que l'échantillon RMN est amené dans la position de transfert (6).

11. Spectromètre RMN selon l'une des revendications précédentes, **caractérisé en ce que** l'angle de l'axe de rotation (30) par rapport à la verticale est compris entre 20 et 25 degrés.

12. Spectromètre RMN selon l'une des revendications précédentes, **caractérisé en ce qu'**un échantillon de calibrage pour le calibrage et l'autosurveillance du spectromètre RMN (1' ; 1" ; 1''') est introduit dans un autre support d'échantillon (7" ; 7a, 7b, 7c, 7e, 7f).
